**Europäisches Patentamt**

**European Patent Office**

**Office européen des brevets**

(19)

(11) Veröffentlichungsnummer: **0 184 117**
**B1**

(12) ## EUROPÄISCHE PATENTSCHRIFT

(45) Veröffentlichungstag der Patentschrift:
02.05.90

(51) Int. Cl.⁴: **H01L 33/00, H01S 3/19**

(21) Anmeldenummer: 85114995.5

(22) Anmeldetag: 26.11.85

(54) **Strahlung erzeugende Halbleiterdiode mit einem kleinflächigen Kontakt mit grossflächigerem Oberflächenschutz.**

(30) Priorität: 03.12.84 DE 3444019

(43) Veröffentlichungstag der Anmeldung:
11.06.86 Patentblatt 86/24

(45) Bekanntmachung des Hinweises auf die Patenterteilung:
02.05.90 Patentblatt 90/18

(84) Benannte Vertragsstaaten:
DE FR GB

(56) Entgegenhaltungen:
EP-A- 0 025 749
FR-A- 2 499 318
US-A- 4 206 468
US-A- 4 350 990

JAPANESE JOURNAL OF APPLIED PHYSICS, Band 21, Nr. 9, Teil 1, September 1982, Seiten 1308-1312, Tokyo, JP; A.K. CHIN et al.: "The reliability of Schottky barrier restricted GaAs/GaA1As LEDs"
PROCEEDINGS OF THE IEEE, Band 6, Nr. 6, Juni 1972, Seiten 726,727; J.C. DYMENT et al.:
"Proton-bombardment formation of stripe-geometry heterostructure lasers of 300 K CW operation"
PATENTS ABSTRACTS OF JAPAN, Band 8, Nr. 239 (E-276)[1676], 2. November 1984 JP - A - 59 119 776

(73) Patentinhaber: Siemens Aktiengesellschaft,
Wittelsbacherplatz 2, D-8000 München 2(DE)

(72) Erfinder: Lauterbach, Christl, Defreggerstrasse 1,
D-8012 Ottobrunn(DE)
Erfinder: Heinen, Jochen, Dr., Dianastrasse 38,
D-8013 Haar(DE)

(56) Entgegenhaltungen: (Fortsetzung)
SIEMENS FORSCHUNGS- UND ENTWICKLUNGS-BERICHTE, Band 11, Nr. 4, 1982, Seiten 209-215, Springer-Verlag, Berlin, DE; J. HEINEN et al.: "High-radiance surface-emitting (In,Ga) (As,P)/InP IREDs with an emission wavelength of 1.3 mum for transmission rates of 34 Mbit/s and 140 Mbit/s" 000
IEE PROCEEDINGS, Band 131, Nr. 5, Oktober 1984, Seiten 309-321, Herts, GB; I.H. WHITE et al.: "Optical bistability in twin-stripe lasers"
JOURNAL OF APPLIED PHYSICS, Band 56, Nr. 3, 1. August 1984, Seiten 710-712, American Institute of Physics, New York, US; D.P. WILT et al.: "Channelled-substrate buried heterostructure InGaAsP/InP lasers with vapor phase epitaxial base structure and liquid phase epitaxial regrowth" 000
JOURNAL OF APPLIED PHYSICS, Band 51, Nr. 1, Januar 1980, Seiten 102-108, American Institute of Physics, New York, US; E.V.K. RAO et al.: "Influence of proton-stripe realization process on the luminescence properties of (AlGa)As double heterostructures"uid phase epitaxial regrowth" 000

## Beschreibung

Die vorliegende Erfindung bezieht sich auf eine Halbleiterdiode nach dem Oberbegriff des Patentanspruches 1.

Zur optischen Nachrichtenübertragung mit Glasfasern werden Strahlung emittierende Lumineszenz(LED-)Dioden bzw. Laserdioden, benötigt. Um eine möglichst hohe Lichteinkopplung in die an die Halbleiterdiode angeschlossene Glasfaser zu erreichen, ist kleinflächige Strahlungsemission der Diode erforderlich. Insbesondere bei Lumineszenzdioden bereitet dies gewisse Schwierigkeiten, da derartige Dioden keine interne Strahlungsbündelung, z.B. wie bei Laserdioden, haben.

Für Laserdioden und Lumineszenzdioden ist es bekannt, einen Aufbau zu wählen, der ein für die erzeugte Strahlung durchlässiges Substrat mit auf dem Substrat befindlichen Schichten einer Doppelheterostruktur umfaßt. Als Halbleitermaterialien für Substrat und Schichten kommen III-V-Halbleitermaterilien in Frage. Indiumphosphid ist z.B. für einen strahlungsdurchlässigen Substratkörper besonders bevorzugt. Doppelhetero-Schichtstrukturen werden aus (In, Ga) (As, P)-Schichten mit jeweils zueinander verändertem Zusammensetzungsgehalt hergestellt.

Der kleinflächige Kontakt wird als ohm'scher Kontakt auf der Doppelhetero-Schichtstruktur aufgebracht. Bei einer LED-Diode wird die an dem Substratkörper angebrachte Glasfaser an der dem kleinflächigen Kontakt gegenüberliegenden Substratfläche angebracht. Es ist dies die bekannte upside-down-Technologie. Bei Streifen-Laserdioden wird die Glasfaser an der Austrittsstelle für die Laserstrahlung am Substratkörper bzw. der Schichtstruktur angebracht.

Es sind bereits Verfahren bekanntgeworden, einen entsprechend kleinflächigen Kontakt für eine LED-Diode oder für den Streifenkontakt einer Laserdiode herzustellen. Bekannt ist der Weg, nach dem Prinzip der Selbstjustierung, den bereits auf die Halbleiteroberfläche aufgebrachten, kleinflächigen Metallkontakt als Maske zu benutzen, um den Kontakt umgebende Bereiche des Halbleitermaterials hochohmig zu machen. Damit wird erreicht, daß die Stromverteilung im Halbleiterkörper bzw. in der Schichtstruktur weitestgehend auf die Fläche des Elektrodenkontaktes beschränkt ist. Entsprechend kleinflächig und konzentriert ist die Strahlungserzeugung im Halbleiterkörper der betreffenden Diode.

Aufgabe der vorliegenden Erfindung ist es, einen Aufbau bzw. ein Herstellungsverfahren für eine solche Laserdiode anzugeben, die einen derartigen kleinflächigen Kontakt verbunden mit einem großflächigeren Oberflächenschutz der Halbleiteroberfläche besitzt.

Diese Aufgabe wird mit einer Strahlung emittierenden Halbleiterdiode gelöst, die die Merkmale des Patentanspruches 1 aufweist bzw. nach dem Patentanspruch 3 hergestellt ist.

Ohm'sche Kontakte auf Halbleitermaterial bzw. Halbleiter-Schichtstrukturen, vorzugsweise auf III-V-Halbleitermaterial, werden mehrschichtig ausgeführt. An sich wird ein Kontakt aus Gold vorgesehen, an den sich insbesondere Anschlußdrähte besonders leicht anbonden lassen. Gold hat aber die nachteilige Eigenschaft, in Halbleitermaterial einzudiffundieren und dort Störungen zu verursachen. Deshalb ist schon seit langem die Verwendung einer Sperrschicht bekannt, z.B. aus Platin, einem Platinmetall, aus Molybdän, Wolfram und dgl. Eine Schicht aus einem derartigen Material hat ggf. schlechte Haftfestigkeit auf Halbleiteroberflächen. Deshalb sind bekannterweise zusätzliche Haftvermittler-Schichten aus Titan (insbesondere für Indiumphosphid) bzw. Chrom (insbesondere für Galliumarsenid) verwendet worden. Ein derartiger bekannter Kontakt besteht somit aus einer Schichtfolge aus (ausgehend von der Halbleiteroberfläche) Titan oder Chrom, darüber Platin oder ein entsprechendes Metall und darauffolgend Gold. Es ist bekannt, bei einem gewollt kleinflächigen Kontakt auf Halbleitermaterial die Eingrenzung des Stromflusses im Halbleitermaterial dadurch zu erreichen, daß in dem unterhalb des Kontaktes liegenden Halbleitermaterial derjenige Anteil des Halbleitermaterials hochohmig gemacht ist, der im Bereich außerhalb der Umgrenzung des Kontaktes liegt. Im Bereich außerhalb des Kontaktes (bei einer LED ein Punktkontakt, bei einer Laserdiode ein Streifenkontakt) läßt sich diese Hochohmigkeit z.B. durch Eindiffusion und/oder durch Gitterstörung, z.B. durch Protonenimplantation, erzielen. Für diesen Verfahrensschritt ist der oben erwähnte dreischichtige Kontakt als selbstjustierende Maske verwendet worden. Ein solches Verfahren ist z.B. aus Siemens Forsch.- u. Entwickl.-Ber., Band II (1982), Nr. 4, Seiten 209–215 bekannt.

Auf diesen verschiedenen Gedanken des Standes der Technik aufbauend beruht die Erfindung darauf, einen vergleichsweise zur Kontaktfläche großflächigeren Oberflächenschutz der Halbleiteroberfläche vorzusehen, wobei dieser Oberflächenschutz ohne weiteren Aufwand bzw. ohne Zusatzmaßnahmen herzustellen ist. Bei der Erfindung wird aber nicht nur zusätzlicher Aufwand eingespart, sondern es wird darüber hinaus sogar das Herstellungsverfahren des Kontaktes selbst vereinfacht, da bei der Erfindung Verfahrensschritte eingespart werden können, die beim Stand der Technik notwendigerweise durchzuführen sind.

In FR-A 2 499 318 ist eine Strahlung erzeugende Halbleiterdiode beschrieben, die einen kleinflächigen Kontakt verbunden mit einem großflächigen Ti-Oberflächenschutz der Halbleiteroberfläche aufweist.

Weitere Erläuterungen der Erfindung werden anhand der nachfolgenden Beschreibung eines erfindungsgemäßen Herstellungsverfahrens und der nach dem Verfahren hergestellten Diode beschrieben.

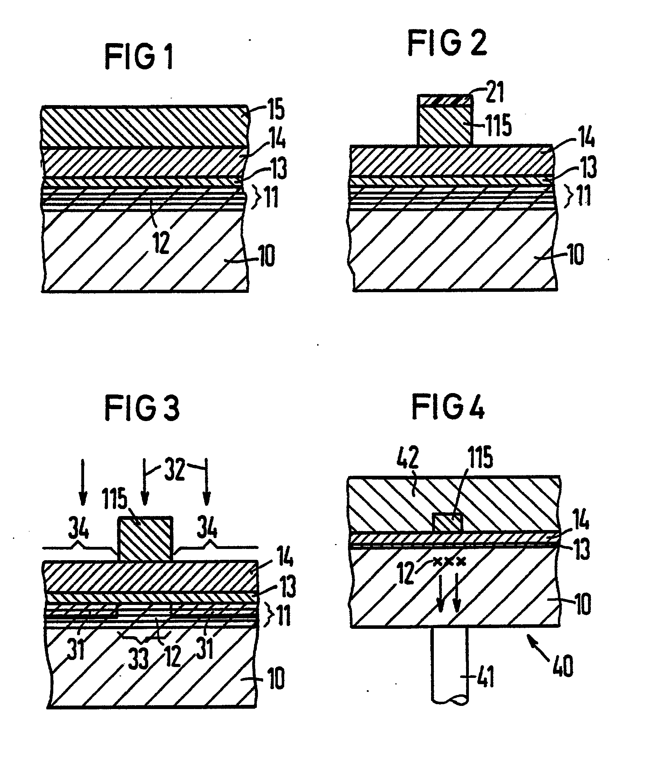

Die Figuren 1 bis 3 zeigen die Verfahrensschritte und die Figur 4 zeigt eine fertige erfindungsgemäße Diode mit angeschlossener Glasfaser.

Figur 1 zeigt mit 10 bezeichnet einen Anteil eines Halbleitersubstratkörpers aus z.B. Indiumphosphid oder Galliumarsenid. Auf der einen Oberfläche dieses Substratkörpers 10 befindet sich ein an sich bekannter Doppel-Heteroschichtstruktur-Aufbau, der insgesamt mit 11 bezeichnet ist. Die in der Schichtstruktur 11 enthaltene Schicht 12 ist im Regelfall diejenige Zone, in der die Strahlungserzeugung erfolgt. Mit 13 ist eine vorzugsweise vorgesehene Schicht aus Titan oder Chrom bezeichnet, die als Haftvermittler dient. Die mit 14 bezeichnete Schicht besteht aus Platin, einem Platinmetall, Molybdän, Wolfram oder dgl. Mit 15 ist eine aus Gold bestehende Schicht bezeichnet. Das Material der Schicht 14 dient dazu, Diffusion des Goldes der Schicht 15 in die Halbleiterschichtstruktur 11 zu verhindern. Für die Schicht 13 sind Dicken zwischen 10 und 20 nm typisch. Damit die Schicht 14 mit der notwendigen Sicherheit die Diffusion des Goldes verhindern kann, ist für die Schicht 14 eine Dicke von wenigstens 30 nm erforderlich. Aus noch nachfolgend näher erörterten Gründen sollte diese Schicht 14 aber nicht zu dick gemacht werden, da durch einen Flächenbereich dieser Schicht hindurch Protonenimplantation in die Schichtstruktur 11 hinein durchzuführen ist. Für das Gold genügt im allgemeinen eine Schicht von 1 μm, wobei die Dicke dieser Schicht so groß gewählt ist, daß die Goldschicht als Implantationsmaske zu verwenden ist.

Figur 2 zeigt das Ergebnis zwei aufeinanderfolgender Verfahrensschritte. Zunächst ist auf die Goldschicht insbesondere auf fotolithografischem Wege eine maskierende Abdeckung 21 aufgebracht worden. Diese Maskierung 21 hat die Flächenabmessungen des gewünschten kleinflächigen Kontaktes. Weiter zeigt die Figur 2 das Ergebnis eines Ätzprozesses, bei dem dasjenige Gold der Schicht 15 entfernt ist, das sich außerhalb des Bereichs der Maskierung 21 befunden hat. Figur 2 zeigt somit den kleinflächigen Goldkontakt 115. Die Schicht 14 hat bei diesem Ätzprozeß als Ätzstopp gewirkt.

Figur 3 zeigt den bei einer LED ringförmigen Bereich 31 bzw. bei einer Laser-Streifendiode die beiden seitlichen Bereiche 31 der Schichtstruktur 11, der bzw. die mit Hilfe der Protonenimplantation 32 hochohmig gemacht worden sind. Der Goldkontakt 115 hat den mit 33 bezeichneten Bereich von der Implantation freigehalten.

Bei der Erfindung ist die Implantation durch den einen bzw. die beiden äußeren Bereiche 34 der Schicht 14 hindurch durchzuführen. Es ist für die Implantations-Strahlenergie ein entsprechender Zuschlag zu machen, z.B. von etwa 10 keV für z.B. 30 bis 40 nm dicke Platinschicht. Die Implantationsenergie liegt in der Größe zwischen 100 und 150 keV, um eine Implantationstiefe bis knapp an die aktive Zone der Schicht 12 zu erreichen, d.h. eine Implantationstiefe von etwa 1 bis 1,5 μm in das Halbleitermaterial hinein zu erzielen.

Figur 4 zeigt eine fertige, nach dem erfindungsgemäßen Verfahren hergestellte Diode 40. Mit 41 ist das Anschlußstück einer Glasfaser bezeichnet, die bei dem dargestellten Beispiel einer LED-Diode an den strahlungsdurchlässigen Substratkörper 10 aus beispielsweise Indiumphosphid angekoppelt ist. Mit 42 ist ein zusätzlich angebrachter, als Wärmesenke dienender Körper bezeichnet. Diese Wärmesenke 42 kann (zusätzlich) durch Aufdampfen oder galvanisch aufgebrachtes Gold sein.

Nach erfolgter Implantation kann eine Temperung bei z.B. 400° C mit einer Dauer von weniger als einer halben Minute vorgesehen sein, die der Erzielung besserer Eigenschaften des Kontaktes dient. Diese Temperung darf aber nicht derart sein, daß die durch die Implantation 32 erzielte Hochohmigkeit in dem einen Bereich bzw. in den Bereichen 31 wieder beseitigt wird.

Bei der Erfindung dient die auch außerhalb des Kontaktes 115 verbleibende Schicht 14 aus insbesondere Platin, Molybdän und dgl. als vorteilhafter Schutz für diejenigen Oberflächenanteile (oberhalb des bzw. der Bereiche 31) der Schichtstruktur 11, die sich über den eigentlichen Bereich des Kontaktes 115 bzw. den Stromfluß-Bereich 33 ringförmig bzw. lateral hinaus erstrecken. Eine derartige Platinschicht 14 kann z.B. in sehr einfacher Weise gereinigt werden. Die erfindungsgemäße Diode wird durch diese Schicht 14 vor Verunreinigungen geschützt. Auch dient diese Schicht 14 dazu, Probleme zu vermeiden, die mit der Anbringung einer üblichen Wärmesenke 42 verbunden sein können.

**Patentansprüche**

1. Strahlung erzeugende Halbleiterdiode mit kleinflächigem Kontakt, geeignet für den Anschluß einer Glasfaser (41) als optische Leitung, mit einem Substratkörper (10) und einer Halbleiter-Schichtstruktur (11) und auf der Oberfläche der Schichtstruktur befindlichem, aus mehreren Metallschichten bestehendem Kontakt, wovon die eine Schicht (15) aus Gold und eine andere Schicht (14) aus einem Metall besteht, das als Diffusionssperre für Gold wirkt, und wobei der außerhalb der Umgrenzung des kleinflächigen Kontaktes vorhandene Bereich der Schichtstruktur aus Halbleitermaterial durch Implantation hochohmig gemacht ist, **gekennzeichnet** dadurch, daß die als Diffusionssperre für das Gold des Kontaktes (115) vorgesehene Schicht (14) sich über die Fläche des Kontaktes (115) hinaus über den hochohmig gemachten Bereich (31) der Schichtstruktur (11) als großflächige Oberflächenschutzschicht erstreckt.

2. Diode nach Anspruch 1, **gekennzeichnet** dadurch, daß das Material der Schutzschicht (14) aus einem Metall der Gruppe Platin, Platinmetall, Molybdän, Wolfram besteht.

3. Verfahren zur Herstellung einer Diode nach Anspruch 1 oder 2, wobei auf der Oberfläche einer Schichtstruktur (11) eines Substratkörpers (10) eine Schichtfolge (14, 15) zur Herstellung eines kleinflächigen Kontaktes (115) aufgebracht wird, wobei das Material der einen Schicht (14) als Diffusionssperre für das Gold der anderen Schicht (15) wirkt und wobei der kleinflächige Kontakt (115) aus Gold durch Ätzen der anderen Schicht (15) hergestellt ist, **gekennzeichnet** dadurch,
- daß die Schicht (14) aus dem als Diffusionssperre für Gold dienendem Metall der Schichtfolge (14, 15) außerhalb des Bereiches des Kontaktes (115) belassen wird, und
- daß die Implantation (32) zur Erzeugung des hochohmigen Bereiches (31) in der Schichtstruktur (11) durch den, außerhalb der Umgrenzung des Kontaktes (115) vorhandenen Bereich (34) der verbliebenen Schicht (14) hindurch ausgeführt wird.

## Claims

1. Radiation-emitting semiconductor diode having a small-area contact, suitable for the connection of a glass fibre (41) as light guide, having a substrate body (10) and a semiconductor layer structure (11) and, situated on the surface of the layer structure, contact consisting of several metal layers, of which one layer (15) is made of gold and another layer (14) is made of a metal that acts as diffusion barrier for gold, and the region of the layer structure which is made of semiconductor material and which lies outside the junction of the small-area contact being made highly resistive by means of implantation, characterized in that the layer (14) provided as diffusion barrier for the gold of the contact (115) extends as large-area surface protection layer over the region (31) of the layer structure (11) made highly resistive.

2. Diode according to Claim 1, characterized in that the material of the protective layer (14) is made of a metal of the group platinum, platinum metal, molybdenum, tungsten.

3. Method of producing a diode according to Claim 1 or 2, in which a sequence of layers (14, 15) is applied to the surface of a layer structure (11) of a substrate body (10) to produce a small-area contact (115), the material of the one layer (14) acting as diffusion barrier for the gold of the other layer (15), and the small-area contact (115) being produced from gold by etching the other layer (15), characterized in that the layer (14) of the metal, serving as diffusion barrier for gold, of the sequence of layers (14, 15) is left alone outside the region of the contact (115), and in that the implantation (32) for creating the highly resistive region (31) in the layer structure (11) is carried out right through the region (34) of the remaining layer (14) which lies outside the junction of the contact (115).

## Revendications

1. Diode semiconductrice émettant un rayonnement et possédant un contact à surface de faible extension, convenant pour le raccordement d'une fibre de verre (41) en tant que conducteur optique, comportant un corps formant substrat (10) et une structure (11) formée de couches semiconductrices et un contact situé plusieurs couches métalliques, dont l'une (15) est en or et dont une autre (14) est réalisée en un métal qui agit en tant que barrière contre la diffusion pour l'or, la zone, présente à l'extérieur de la limite du contact à surface de faible extension, de la structure à couches étant formée avec une forte valeur ohmique par implantation dans le matériau semiconducteur, caractérisée par le fait que la couche (14) prévue en tant que barrière contre la diffusion pour l'or du contact (115) s'étend au-delà de la surface du contact (115), sur la zone (31), rendue fortement ohmique de la structure à couches (11), en tant que couche de protection superficielle à surface de grande extension.

2. Diode suivant la revendication 1, caractérisée par le fait que le matériau de la couche protectrice (14) est un métal du groupe: platine, du platine métallique, du molybdène, du tungstène.

3. Procédé pour fabriquer une diode suivant la revendication 1 ou 2, selon lequel on dépose, sur la surface d'une structure à couches (11) d'un corps formant substrat (10), une succession de couches (14, 15) pour fabriquer un contact à surface de faible extension (115), et selon lequel le matériau d'une couche (14) agit en tant que barrière contre la diffusion pour l'or de l'autre couche (15), et le contact à surface de faible extension (115) est réalisé en or, par corrosion de l'autre couche (15), caractérisée par le fait

– qu'on laisse en place la couche (14), constituée par le métal utilisé en tant que barrière contre la diffusion pour l'or, de la succession de couches (14, 15) à l'extérieur de la zone du contact (115),

– qu'on réalise l'implantation (32) pour produire la zone de forte valeur ohmique (31) dans la structure à couches (11), à travers la zone (34) de la couche subsistante (14), qui est présente à l'extérieur de la limite du contact (115).

# FIG 1

15
14
13
> 11
12
10

# FIG 2

21
115
14
13
> 11
10

# FIG 3

32
115
34    34
31    31
33  12
14
13
> 11
10

# FIG 4

42    115
14
13
12
10
40
41